# EUROPEAN PATENT APPLICATION

(11) **EP 4 386 833 A1**
(43) Date of publication of application: **19.06.2024**
(21) Application number: 21961718.0
(22) Date of filing: 27.10.2021
(51) Int. Cl.: H01L 23/473, H05K 7/20

(54) **HEAT DISSIPATION SYSTEM, ELECTRONIC DEVICE, AND LIQUID COOLING SYSTEM**

(71) Applicant: Huawei Technologies Co., Ltd., Shenzhen, Guangdong 518129 (CN)
(72) Inventor: LU, Jun, Shenzhen, Guangdong 518129 (CN); ZHENG, Jiantao, Shenzhen, Guangdong 518129 (CN); SU, Yu, Shenzhen, Guangdong 518129 (CN); ZHU, Longguang, Shenzhen, Guangdong 518129 (CN); DAI, Shujun, Shenzhen, Guangdong 518129 (CN); CHEN, Jinyu, Shenzhen, Guangdong 518129 (CN); XIONG, Wei, Shenzhen, Guangdong 518129 (CN)
(74) Representative: Grünecker Patent- und Rechtsanwälte PartG mbB
(86) International application number: PCT/CN2021/126533
(87) International publication number: WO 2023/070342

(57) **Abstract**

This application relates to the field of heat dissipation technologies, and specifically, to a heat dissipation system, an electronic device, and a liquid cooling system. The heat dissipation system includes: a jet cooling assembly, where the jet cooling assembly has a coolant liquid inlet and a jet hole, and the jet hole faces a heat generating device; a sealing part, configured to seal a part between an end part of the jet cooling assembly and a surface of the heat generating device; a rigid topplate, around the heat generating device, disposed on a side that is of a substrate; a rigid backplate, clamping the substrate together with the rigid topplate; and a rigid position limiting structure, fastened to the substrate with the rigid topplate and/or the rigid backplate through connectors. There is height limiting space between the substrate and the rigid position limiting structure, and at least a part of the jet cooling assembly is located in the height limiting space. The height limiting space limits movement of the jet cooling assembly in a direction away from the heat generating device, to keep the sealing part in a sealed state. Therefore, in this application, the heat dissipation system reduces a possibility of a leakage of a coolant flowing into a coolant outflow chamber.

## Description

### TECHNICAL FIELD

This application relates to the field of heat dissipation technologies, and in particular, to a heat dissipation system, an electronic device, and a liquid cooling system.

### BACKGROUND

As power consumption of a heat generating device like a chip continuously increases, a heat dissipation problem of the chip is one of bottlenecks that limit chip development. Liquid cooling technologies are gradually used because of a strong heat dissipation capability. Inject cooling is a liquid cooling technology that is one of the most known ultimate solutions for heat dissipation.

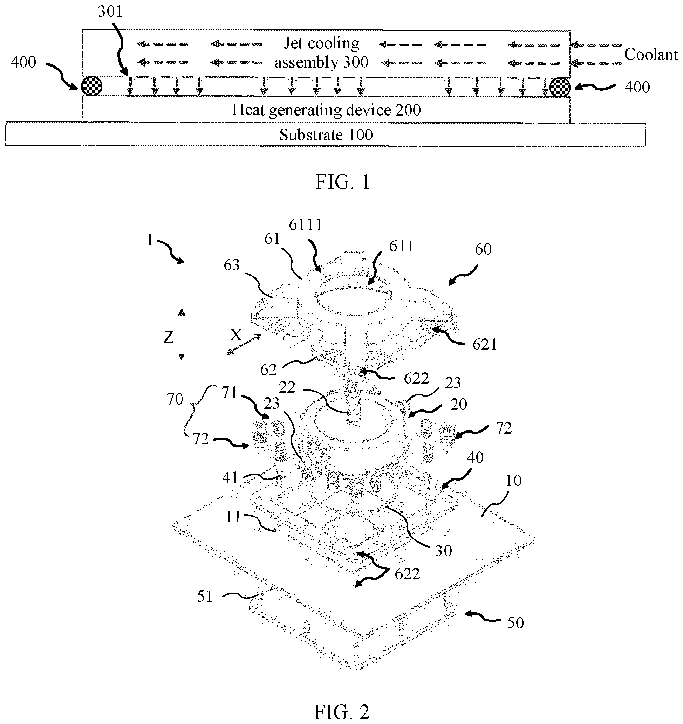

As shown in FIG. 1, a heat generating device 200 is disposed on a substrate 100, and the heat generating device 200 is, for example, a chip. A jet cooling assembly 300 is disposed above the chip, and the jet cooling assembly 300 has a spray nozzle 301. The jet cooling assembly 300 sprays a cooling medium (for example, a coolant) to the chip that needs to be cooled through the spray nozzle 301, to directly dissipate heat for the chip. A sealing part 400 (for example, an O-shaped rubber ring) is disposed between the heat generating device 200 and the jet cooling assembly 300, so that the jet cooling assembly 300, the heat generating device 200, and the sealing part 400 form a sealed coolant outflow chamber. The coolant sprayed to a surface of the heat generating device 200 flows into the coolant outflow chamber, and then flows out of the coolant outflow chamber.

When the sealing part 400 cannot be well compressed, sealing performance of the coolant outflow chamber is not well, and there is a huge hazard of liquid leakage. Especially in preservation reliability tests of several times of atmospheric pressure, sealing effect of the coolant outflow chamber needs to be maintained. Therefore, sealing reliability of the coolant outflow chamber is particularly important.

### SUMMARY

Embodiments of this application provide a heat dissipation system. Sealing performance of a coolant outflow chamber of the heat dissipation system is good, and a possibility of a coolant leakage is reduced.

To achieve the foregoing objectives, the following technical solutions are used in embodiments of this application.

According to a first aspect, this application provides a heat dissipation system, configured to dissipate heat for a heat generating device on a substrate, where the heat dissipation system includes: a jet cooling assembly, where the jet cooling assembly has a coolant liquid inlet and a jet hole, and the jet hole faces the heat generating device; and the heat generating device is disposed on a side that is of the substrate and that faces the jet cooling assembly, and an end part of the jet cooling assembly is in contact with a surface of the heat generating device; a sealing part, configured to seal a part between the end part of the jet cooling assembly and the surface of the heat generating device; a coolant outflow chamber, where the coolant outflow chamber is at least formed by the sealing part, the jet cooling assembly, and the heat generating device, and the jet hole communicates with the coolant outflow chamber; a rigid topplate, around the heat generating device, disposed on a side that is of the substrate; a rigid backplate, disposed opposite to the rigid topplate on the other side of the substrate and clamping the substrate together with the rigid topplate; and a rigid position limiting structure, fastened to the substrate with the rigid topplate and/or the rigid backplate through connectors, where in a first direction perpendicular to the substrate, there is height limiting space between the substrate and the rigid position limiting structure, and at least a part of the jet cooling assembly is located in the height limiting space; and in the first direction, one end of the part of the jet cooling assembly located in the height limiting space is in contact with the heat generating device, and the other end is in contact with the rigid position limiting structure.

In this embodiment, the rigid position limiting structure is fastened to the substrate together with the rigid topplate and the rigid backplate through connectors. In some possible implementations, the rigid position limiting structure is fastened to the substrate with the rigid topplate through connectors. Alternatively, in some possible implementations, the rigid position limiting structure is fastened to the substrate with the rigid backplate through connectors.

According to an implementation of this application, a coolant flows into the coolant liquid inlet of the jet cooling assembly, the jet cooling assembly sprays the coolant flowing in to the surface of the heat generating device through the jet hole, the coolant obtained after heat dissipation for the heat generating device flows into the coolant outflow chamber and flows out of the jet cooling assembly through the coolant outflow chamber, to take away heat of the heat generating device. This implements heat dissipation of the heat generating device.

To maintain sealing performance of the coolant outflow chamber and reduce a possibility of a leakage of the coolant in the coolant outflow chamber, in this application, the rigid position limiting structure, the rigid topplate, and the rigid backplate are disposed on the substrate. In the first direction of the heat dissipation system, the rigid topplate and the rigid backplate are located on two opposite sides of the substrate, and the rigid topplate and the rigid backplate jointly clamp the substrate. This is similar to a "sandwich" structure, and can enhance rigidity of the substrate. Therefore, after the three components, namely, the rigid position limiting structure, the rigid topplate, and the rigid backplate, are fastened through the connectors, there is height limiting space between the substrate and the rigid position limiting structure in the first direction.

At least a part of the jet cooling assembly is located in the height limiting space, and in the first direction, one end of the part of the jet cooling assembly located in the height limiting space is in contact with the heat generating device, and the other end is in contact with the rigid position limiting structure.

Therefore, in the first direction, the height limiting space limits movement of the jet cooling assembly in a direction away from the heat generating device, to keep the sealing part in a sealed state. Because the sealing part is located between the jet cooling assembly and the heat generating device, after the height limiting space effectively limits the movement of the jet cooling assembly in the first direction, separation of the sealing part and the jet cooling assembly can be prevented, and the sealing part is well compressed, so that the coolant outflow chamber has good sealing effect. Therefore, in this application, the sealing part can well isolate the coolant in the coolant outflow chamber, prevent the coolant from flowing out of the substrate, and avoid a short circuit of a component and a line outside the substrate.

In a possible implementation of the first aspect, the rigid position limiting structure includes: an accommodating part, configured to accommodate the jet cooling assembly; and a connecting part, extending outwards from an outer surface of the accommodating part, where the connecting part is fastened to the substrate with the rigid topplate and/or the rigid backplate through the connectors, and there is the height limiting space between the substrate and the accommodating part; and in the first direction, the other end of the jet cooling assembly is in contact with the accommodating part.

The accommodating part is used to accommodate the jet cooling assembly, and in the first direction, the other end of the jet cooling assembly is in contact with the accommodating part. This limits the movement of the jet cooling assembly in the first direction. It is equivalent to that the accommodating part "encircles" the jet cooling assembly, and after the accommodating part is fastened to the substrate through the connecting part, the accommodating part can reliably implement a limiting function, limit the movement of the jet cooling assembly in the first direction, and improve the sealing performance of the coolant outflow chamber.

In a possible implementation of the first aspect, the rigid position limiting structure further includes: a sleeve, where an inner chamber of the sleeve is the accommodating part, and the inner chamber of the sleeve adapts to a shape of the jet cooling assembly; and the connecting part is a flange, the flange is formed by extending outwards in a radial direction from an end part that is of the sleeve and that faces the substrate, and the radial direction is perpendicular to the first direction. The accommodating part is formed through the sleeve. This is convenient for processing. The flange is used as the connecting part. This facilitates the sleeve to implement a connection between the rigid topplate and the rigid backplate.

In a possible implementation of the first aspect, a plurality of ribs are further included, and two ends of each of the ribs are respectively connected to the flange and the sleeve. Strength of the rigid position limiting structure can be improved by setting the ribs. When the heat dissipation system is in a working state, a coolant is introduced into the jet cooling assembly, and back pressure is generated. In this case, after the strength of the rigid position limiting structure is increased, a service life of the rigid position limiting structure is prolonged, and it is ensured that the sealing part is in the sealed state for long time. In this way, a service life of the heat dissipation system is prolonged.

In a possible implementation of the first aspect, the connector includes: a plurality of topplate screws, disposed on a side that is of the rigid topplate and that is opposite to the substrate, where each of the topplate screws is configured to pass through the connecting part; and a plurality of nut groups, one-to-one corresponding to the topplate screws, each of the nut groups includes two washers and two nuts, each of the nut groups clamps upper and lower sides of the connecting part through one of the topplate screws, and in the first direction, the two washers are respectively attached to the upper and lower sides of the connecting part.

Therefore, the rigid position limiting structure and the rigid topplate are fastened through the two nuts, and connection stability is good and this is not easy to loosen. In the working state, the heat dissipation system effectively limits movement of the jet cooling assembly in the first direction, prevents the sealing part from being separated from the jet cooling assembly, and the sealing part is well compressed, so that the coolant outflow chamber has good sealing effect.

In a possible implementation of the first aspect, the nut in the nut group is a hexagonal nut. The hexagonal nut has large fastening force, can be operated with a hexagonal wrench, and is easy to install and disassemble.

In a possible implementation of the first aspect, the connector further includes a plurality of groups of spring screws, and each group of the spring screws is located on the upper side of the connecting part, and fastens the connecting part, the rigid topplate, the substrate, and the rigid backplate in sequence.

In a possible implementation of the first aspect, the connector further includes a plurality of backplate screws, disposed on a side that is of the rigid backplate and that faces the substrate, and one-to-one corresponding to the spring screws, where each of the backplate screws has an inner thread, and the backplate screw is configured to pass through the substrate, the rigid topplate, and the connecting part in sequence, so that the spring screw is in a thread connection with the inner thread of the corresponding backplate screw.

That is, the connecting part of the rigid position limiting structure, the rigid topplate, and the rigid backplate are fastened to the substrate through the spring screws. That the spring screws serve as the connectors can control installation force between the connecting part, the rigid topplate, and the rigid backplate, to prevent the heat generating device from being damaged due to excessive force.

In addition, in this application, after the rigid position limiting structure, the rigid topplate, and the rigid backplate are fastened to each other through the spring screws and the nut groups, an overall high rigid design is implemented. In addition to reducing pressure on a contact surface of the heat generating device, overall deformation of the heat dissipation system, especially deformation of the sealing part, is limited. This avoids a leakage of the coolant in the coolant outflow chamber, and avoids damage to the heat generating device.

In a possible implementation of the first aspect, the connector includes eight nut groups, and the eight nut groups are distributed on the heat dissipation system in an annular manner. This improves connection stability between the rigid position limiting structure and the rigid topplate. In addition, in a process in which the rigid position limiting structure is connected to the rigid topplate, action force is applied to the jet cooling assembly, and the jet cooling assembly compresses the sealing part located between the jet cooling assembly and the heat generating device. After the eight nut groups are disposed, it can be ensured that the sealing part evenly bears force.

In a possible implementation of the first aspect, the connector includes: a plurality of topplate screws, disposed on a side that is of the rigid topplate and that is opposite to the substrate, where every two of the topplate screws are located on a same side of peripheries of the rigid topplate, each of the topplate screws is configured to pass through the connecting part, and each of the topplate screws has an inner thread; and a plurality of fastening springs, where each of the fastening springs corresponds to two of the topplate screws on the same side, locking holes are respectively disposed at two ends of each of the fastening springs, and each of the locking holes is configured for a locking screw to pass through, so that the locking screw is in a thread connection with the inner thread of the corresponding topplate screw.

The rigid backplate, the rigid topplate, and the rigid position limiting structure are fastened in a "single nut" form, and the rigid topplate and the rigid position limiting structure are fastened without using the nut groups. This reduces a quantity of nuts, and reduces costs. In addition, because the fastening springs are connected to two topplate screws at the same time, a connection point between the rigid topplate and the connecting part of the rigid position limiting structure can be prevented from loosening.

In a possible implementation of the first aspect, a nut slot is disposed on a surface that is of each of the fastening springs and that faces the connecting part, and the connector further includes: a plurality of additional backplate screws, disposed on a side that is of the rigid backplate and that faces the substrate, and one-to-one corresponding to the fastening springs, where each of the additional backplate screws is configured to pass through the substrate, the rigid topplate, and the connecting part in sequence; and a plurality of upper nuts, one-to-one corresponding to the additional backplate screws, where each of the upper nuts is located on an upper side of the connecting part, and the upper nut is in a thread connection with a part that is of the additional backplate screw and that extends out of the connecting part, so that the rigid backplate, the rigid topplate, and the connecting part are fastened, and each of the upper nuts is circumferentially limited in the nut slot of the corresponding fastening spring.

After the upper nut is in the thread connection with the part that is of the additional backplate screw and that extends out of the connecting part (in the "single nut" connection form), each of the upper nuts is circumferentially limited in the nut slot of the corresponding fastening spring. In this way, the nut slot for fastening a rear side of the fastening spring may be fastened to the upper nut, to meet a limiting requirement. The fastening spring is configured to limit rotation of the upper nut. This can effectively prevent the upper nut from loosening, especially during transportation.

In a possible implementation of the first aspect, the upper nut is a hexagonal nut, the nut slot is a hexagonal nut slot, and the hexagonal nut is limited in the hexagonal nut slot. There is no need to set a circumferential limiting structure in a new structure form, and conventional hexagonal nuts are directly used. An outer circumferential surface of the hexagonal nut is not a round surface, and after the hexagonal nut cooperates with the hexagonal nut slot, a circumferential limiting function can be implemented.

According to a second aspect, this application provides an electronic device, including the heat dissipation system and the heat generating device according to any one of the first aspect. The heat dissipation system is configured to dissipate heat of the heat generating device in the electronic device. The electronic device uses the heat dissipation system, so that a possibility of a leakage of a coolant is reduced, and maintenance costs of the electronic device are reduced.

According to a third aspect, this application provides a liquid cooling system, including: the electronic device according to the second aspect, and a cooling apparatus, where the cooling apparatus is connected to a jet cooling assembly through a pipe, to provide a coolant for the jet cooling assembly.

### BRIEF DESCRIPTION OF DRAWINGS

FIG. 1 is a schematic diagram of a structure of a heat dissipation system according to some embodiments of this application;
FIG. 2 is a three-dimensional exploded view 1 of a heat dissipation system according to some embodiments of this application;
FIG. 3 is a sectional view of a heat dissipation system according to some embodiments of this application;
FIG. 4 is a three-dimensional view 1 of a heat dissipation system according to some embodiments of this application;
FIG. 5 is a side view 1 of a heat dissipation system according to some embodiments of this application;
FIG. 6 is a partial enlarged view of a heat dissipation system according to some embodiments of this application;
FIG. 7 is a three-dimensional exploded view 2 of a heat dissipation system according to some embodiments of this application;
FIG. 8 is a side view 2 of a heat dissipation system according to some embodiments of this application;
FIG. 9 is a three-dimensional view 2 of a heat dissipation system according to some embodiments of this application; and
FIG. 10 is a three-dimensional view of a fastening spring in a heat dissipation system according to some embodiments of this application.

### Descriptions of reference numerals:

### Conventional technology:

100: substrate;
200: heat generating device;
300: jet cooling assembly; 301: spray nozzle; and
400: sealing part.

### This application:

1: heat dissipation system;
10: substrate; 11: heat generating device;
20: jet cooling assembly; 21: coolant outflow chamber; 22: coolant inflow channel; 221: liquid inlet; 23: coolant outflow channel; 231: liquid outlet; 232: end part of the coolant outflow channel; 233: open end of the coolant outflow channel;
30: sealing part;
40: rigid topplate; 41: topplate screw;
50: rigid backplate; 51: backplate screw; 52: additional backplate screw;
60: rigid position limiting structure; 61: sleeve; 611: accommodating part; 6111: blocking part; 612: via; 62: connecting part; 621: topplate screw via; 622: backplate screw via; 63: rib;
70: connector; 71: nut group; 711: washer; 712: nut; 72: spring screw; 73: upper nut;
80: fastening spring; 81: locking hole; 83: nut slot; and
90: locking screw.

### DESCRIPTION OF EMBODIMENTS

The following describes specific implementations of this application in detail with reference to accompanying drawings.

This application provides a heat dissipation system. Movement of a jet cooling assembly in the heat dissipation system in a first direction is limited, to prevent a sealing part from being separated from the jet cooling assembly. This maintains sealing performance of a coolant outflow chamber, and reduces a possibility of a leakage of a coolant in the coolant outflow chamber. For example, the heat dissipation system provided in this application is applied to an electronic device like a server. The server is, for example, a blade server or a rack server.

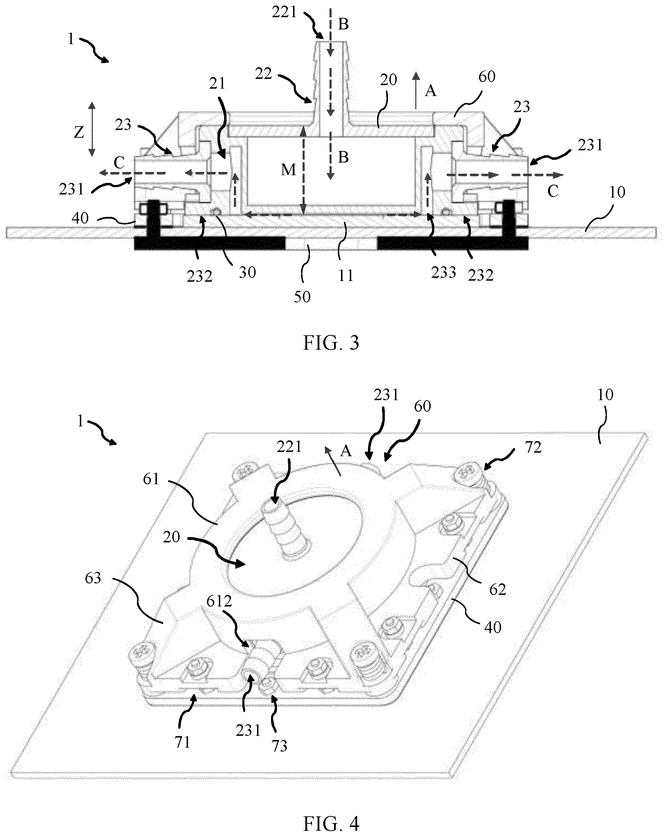

As shown in FIG. 2 and FIG. 3, a heat dissipation system 1 in this application includes a substrate 10, a jet cooling assembly 20, a sealing part 30, a rigid topplate 40, a rigid backplate 50, and a rigid position limiting structure 60. A heat generating device 11 is disposed on a side that is of the substrate 10 and that faces the jet cooling assembly 20, and the substrate 10 is, for example, a PCB board (Printed Circuit Board). An end part (an end part 232 described below) of the jet cooling assembly 20 is in contact with the heat generating device 11. The jet cooling assembly 20 has a coolant liquid inlet 221 and a jet hole, and the jet hole faces the heat generating device 11. The coolant liquid inlet 221 allows a coolant to flow in (where a dashed arrow B in FIG. 3 shows that the coolant flows in), and sprays the inflow coolant to a surface of the heat generating device 11 through the jet hole, to dissipate heat for the heat generating device 11. For example, the coolant liquid inlet 221 of the jet cooling assembly 20 may be directly connected to a CDU (Coolant Distribution Unit, coolant distribution unit), and the CDU provides a coolant for the jet cooling assembly 20.

As shown in FIG. 2 and FIG. 3, the sealing part 30 is located between the jet cooling assembly 20 and the heat generating device 11, and the sealing part 30 is configured to seal a part between the end part 232 of the jet cooling assembly 20 and the surface of the heat generating device 11. For example, the sealing part 30, the jet cooling assembly 20, and the heat generating device 11 form a coolant outflow chamber 21, and the coolant outflow chamber 21 is configured to accommodate the coolant obtained after heat dissipation is performed on the heat generating device 11. The coolant outflow chamber 21 communicates with the jet hole of the jet cooling assembly 20. That is, the heat generating device 11, the jet cooling assembly 20, and the sealing part 30 form the sealed coolant outflow chamber 21, and the coolant obtained after heat dissipation is performed on the heat generating device 11 flows out of the jet cooling assembly 20 through the coolant outflow chamber 21 (where a dashed arrow C in FIG. 3 shows that the coolant flows out).

As shown in FIG. 2, the rigid topplate 40 in this application, around the heat generating device 11, is disposed on a side that is of the substrate 10. An example in which the heat generating device 11 is a chip is used for description. The chip is in a square shape, the rigid topplate 40 has a square-shaped hollow-out structure, and the hollow-out structure of the rigid topplate 40 is disposed around peripheries of the chip. A shape of the chip is not limited thereto, and may be, for example, a circle or a rectangle. Correspondingly, a shape of the hollow-out structure of the rigid topplate 40 adapts to the shape of the chip, to be disposed around the chip.

As shown in FIG. 3, in this application, the rigid topplate 40 is disposed opposite to the rigid backplate 50 on the other side of the substrate 10. In other words, in the first direction (as shown in a Z direction in FIG. 2 and FIG. 3) of the heat dissipation system 1, the rigid topplate 40 and the rigid backplate 50 are located on two opposite sides of the substrate 10, and the rigid topplate 40 and the rigid backplate 50 jointly clamp the substrate 10. This is similar to a "sandwich" structure, and can enhance rigidity of the substrate 10.

Refer to FIG. 3 and FIG. 4. The rigid topplate 40 and the rigid backplate 50 of the rigid position limiting structure 60 are fastened to the substrate 10 through connectors 70 (where a specific structure of the connector 70 is described in detail below). After the three components, namely, the rigid position limiting structure 60, the rigid topplate 40, and the rigid backplate 50, are fastened through the connectors 70, there is height limiting space (as shown by M in FIG. 3) between the substrate 10 and the rigid position limiting structure 60 in the first direction, and at least a part of the jet cooling assembly 20 is located in the height limiting space. For example, the coolant liquid inlet 221 of the jet cooling assembly 20 is located outside the height limiting space.

In the first direction, one end of the part of the jet cooling assembly 20 located in the height limiting space is in contact with the heat generating device 11, and the other end is in contact with the rigid position limiting structure 60. Therefore, in the first direction, the height limiting space limits movement of the jet cooling assembly 20 in a direction (as shown in a direction A in FIG. 3 and FIG. 4) away from the heat generating device 11, to keep the sealing part 30 in a sealed state.

Because the coolant of the jet cooling assembly 20 comes from the CDU, there is always back pressure (for example, one to four times of atmospheric pressure) in a jet chamber (a chamber into which the coolant flows) of the jet cooling assembly 20. In addition, an instantaneous ultimate scenario needs to be considered in a reliability test. Therefore, there is a universal industry standard for a pressure preservation test of several times of atmospheric pressure (for example, two to seven times of atmospheric pressure).

However, in this application, when the heat dissipation system 1 is in a working state, in other words, after the coolant enters from the liquid inlet 221 of the jet cooling assembly 20 (where back pressure is generated), the height limiting space limits movement of the jet cooling assembly 20 in the direction (as shown in the direction A in FIG. 3 and FIG. 4) away from the heat generating device 11, to keep the sealing part 30 in the sealed state.

Because the sealing part 30 is located between the jet cooling assembly 20 and the heat generating device 11, after the height limiting space effectively limits the movement of the jet cooling assembly 20 in the first direction, separation of the sealing part 30 and the jet cooling assembly 20 can be prevented, and the sealing part 30 is well compressed, so that the coolant outflow chamber 21 has good sealing effect. In addition, in a pressure preservation test, the height limiting space can also effectively limit the movement of the jet cooling assembly 20 in the first direction. Therefore, in this application, the sealing part 30 can well isolate the coolant in the coolant outflow chamber 21, prevent the coolant from flowing out of the substrate 10, and avoid a short circuit of a component and a line outside the substrate 10.

In addition, as described above, in this application, after the three components, namely, the rigid position limiting structure 60, the rigid topplate 40, and the rigid backplate 50 are fastened through the connectors 70, movement of the jet cooling assembly 20 in the first direction is limited by the height limiting space, so that the sealing part 30 remains in the sealed state. After such setting, pressure of a contact surface between the jet cooling assembly 20 and the heat generating device 11 (for example, a chip) can be reduced. This avoids damage to the heat generating device 11.

It should be noted that a specific type of the heat generating device 11 is not limited. For example, the heat generating device 11 is a low-power consumption component (for example, a memory module, a PCIE card, a RAID card, or a hard disk) or a high-power consumption component (for example, a CPU, a GPU, or a chip). A manner of connecting the jet cooling assembly 20 to the CDU is not limited either. For example, the jet cooling assembly 20 may be connected to the CDU through a quick connector, or the like, and the quick connector may support automatic liquid shutdown when the coupling is plugged or unplugged. In addition, in this application, a type of the sealing part 30 is not limited, and all sealing parts that can implement a sealing function fall within the protection scope of this application. For example, the sealing part 30 is an O-shaped rubber ring.

In addition, the rigid topplate 40, the rigid backplate 50, and the rigid position limiting structure 60 are made of rigid materials. A specific type of the rigid material is not limited, for example, is stainless steel or copper.

As described above, the jet cooling assembly 20 is configured to spray the coolant to the surface of the heat generating device 11, to implement liquid cooling for the heat generating device 11. This liquid cooling manner for the heat generating device 11 is "jet impingement cooling". The jet impingement (Jet Impingement) is a process in which a liquid or gas is jetted vertically (or at a specific angle) to a cooled surface through a circular or narrow-slit spray nozzle under a pressure difference, so that strong heat exchange effect is generated in an area directly impacted.

A specific structure of the jet cooling assembly 20 is not limited in this application, and a structure form that can implement jet impingement cooling for the heat generating device 11 falls within the protection scope of this application. This application is described by using a structure of the jet cooling assembly 20 shown in FIG. 2 and FIG. 3 as an example.

Refer to FIG. 2 and FIG. 3. In this application, a body of the jet cooling assembly 20 is cylindrical. The jet cooling assembly 20 includes: one coolant inflow channel 22 and two coolant outflow channels 23, where the coolant inflow channel 22 has the liquid inlet 221, and the coolant outflow channels 23 has liquid outlets 231. That is, the jet cooling assembly 20 has one liquid inlet 221 and two liquid outlets 231. One end that is of the coolant inflow channel 22 and on which the liquid inlet 221 is disposed is protrudingly disposed on the body of the jet cooling assembly 20, and extends in the first direction (as shown in the Z direction in FIG. 2 and FIG. 3). Two ends that are of the coolant outflow channels 23 and on which liquid outlets 231 are disposed are also separately protrudingly disposed on the body of the jet cooling assembly 20, and extend in a direction perpendicular to the first direction (for example, a radial direction, as shown in an X direction in FIG. 2).

In addition, in this application, a jet hole (not shown in the figure) disposed facing the heat generating device 11 is disposed on the coolant inflow channel 22, the coolant outflow channels 23 are disposed around the coolant inflow channel 22, and the end parts 232 of the coolant outflow channels 2 are in contact with the surface of the heat generating device 11. The coolant outflow channels 23 have open ends 233, and the open ends 233 of the coolant outflow channels 23 and the end parts 232 of the coolant outflow channels 23 are located on a same side of the jet cooling assembly 20. The end parts 232 of the coolant outflow channels 23 compress the sealing part 30, the sealing part 30 seals the open ends 233 of the coolant outflow channels 23 and the surface of the heat generating device 11, and the open ends 233 of the coolant outflow channels 23 are covered by the surface of the heat generating device 11, so that the coolant outflow channels 23, the sealing part 30, and the heat generating device 11 form the sealed coolant outflow chamber 21. The liquid inlet 221 of the coolant inflow channel 22 is, for example, connected to a CDU, the CDU provides the coolant for the liquid inlet 221, and the coolant flows into an internal channel chamber of the coolant inflow channel 22 from the liquid inlet 221. For ease of description, the internal channel chamber of the coolant inflow channel 22 is referred to as a jet chamber below. After the coolant enters the jet chamber, a high-speed jet is formed. The high-speed jet impacts a heat generating surface of the heat generating device 11, that is, the coolant in the jet chamber sprays the coolant to the surface of the heat generating device 11 through the jet hole, to implement liquid cooling for the heat generating surface of the heat generating device 11. The coolant obtained after heat dissipation for the heat generating device 11 flows into the coolant outflow channels 23, and then flows out from the liquid outlets 231 of the coolant outflow channels 23, for example, flows back to the CDU.

Refer to FIG. 2 and FIG. 4. To limit the movement of the jet cooling assembly 20 shown in FIG. 2 and FIG. 3 in the first direction, the rigid position limiting structure 60 in this application includes the accommodating part 611 and the connecting part 62. The accommodating part 611 is configured to accommodate the body of the jet cooling assembly 20. The connecting part 62 extends outwards from an outer surface of the accommodating part 611, and the connecting part 62 is fastened to the substrate 10 with the rigid topplate 40 and the rigid backplate 50 through the connectors 70. After the connecting part 62, the rigid topplate 40, and the rigid backplate 50 are fastened, there is the height limiting space between the substrate 10 and the accommodating part 611. In the first direction, one end of the jet cooling assembly 20 is in contact with the heat generating device 11, and the other end is in contact with a top wall of the accommodating part 611. In this way, the height limiting space limits the movement of the jet cooling assembly 20 in the direction away from the heat generating device 11, to keep the sealing part 30 in the sealed state.

A specific structure of the rigid position limiting structure 60 is not limited, and a structure that can accommodate the jet cooling assembly 20 falls within the protection scope of this application. Refer to FIG. 2 and FIG. 4. In some possible implementations, the rigid position limiting structure 60 further includes the sleeve 61.

An inner chamber of the sleeve 61 serves as the accommodating part 611, the inner chamber of the sleeve 61 adapts to a shape of the jet cooling assembly 20, and the inner chamber of the sleeve 61 accommodates the body of the jet cooling assembly 20. For example, the body of the jet cooling assembly 20 is cylindrical, and correspondingly, the inner chamber of the sleeve 61 is also cylindrical. In addition, two ends of the sleeve 61 in the first direction have openings, and an opening at one end, back to the substrate 10, of the sleeve 61 in the first direction has a blocking part 6111. An outer circumferential surface of the sleeve 61 is provided with the vias 612 (refer to FIG. 4) for the two coolant outflow channels 23 of the jet cooling assembly 20 to extend out.

In this way, after the body of the jet cooling assembly 20 is accommodated in the inner chamber of the sleeve 61, the coolant inflow channel 22 of the jet cooling assembly 20 extends from the opening at one end, back to the substrate 10, of the sleeve 61 in the first direction, and abuts against the blocking part 6111 on the sleeve 61 in the first direction, and the two coolant outflow channels 23 of the jet cooling assembly 20 extend from the two vias 612 on the outer circumferential surface of the sleeve 61.

The connecting part 62 is a flange, and the flange is formed by an end part of the sleeve 61 facing the substrate 10 extending outwards in the radial direction (as shown in the X direction in FIG. 2). The radial direction is perpendicular to the first direction. The flange is in contact with the rigid topplate 40, and a shape of the flange adapts to the rigid topplate 40. For example, the rigid topplate 40 is in a square shape, and correspondingly, the flange is in a square shape.

In addition, as shown in FIG. 2 and FIG. 4, the rigid position limiting structure 60 further includes a plurality of ribs 63, and two ends of each rib 63 are respectively connected to the flange and the sleeve 61. Disposing of the ribs 63 may improve strength of the rigid position limiting structure 60. A quantity of the ribs 63 is not limited in this application. FIG. 2 and FIG. 4 show four ribs 63 distributed at four corners of the rigid position limiting structure 60. In some possible implementations, another quantity of, for example, 5 or 6, ribs 63 may be disposed based on an actual requirement.

The following describes in detail a specific structure of the connector 70 in the heat dissipation system 1 with reference to the accompanying drawings. The specific structure of the connector 70 is not limited in this application, and a structure in which the rigid position limiting structure 60, the rigid topplate 40, and the rigid backplate 50 can be fastened falls within the protection scope of this application.

First, the structure of the connector 70 between the rigid topplate 40 and the rigid position limiting structure 60 is described. Refer to FIG. 2 and FIG. 4 to FIG. 7. The connector 70 includes a plurality of topplate screws 41 and a plurality of nut groups 71. The plurality of topplate screws 41 are disposed on a side that is of the rigid topplate 40 and that is opposite to the substrate 10, and topplate screw vias 621 one-to-one corresponding to the topplate screws 41 are disposed on the connecting part 62, where each of the topplate screws 41 is configured to pass through the topplate screw via 621 on the connecting part 62.

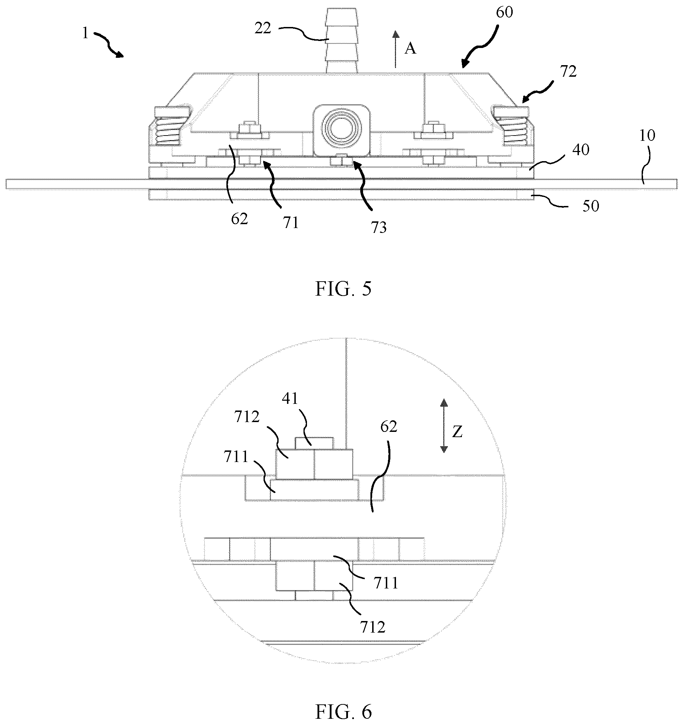

The plurality of nut groups 71 one-to-one correspond to the plurality of topplate screws 41. Each of the nut groups 71 includes two washers 711 and two nuts 712. Each of the nut groups 71 clamps upper and lower sides of the connecting part 62 in the first direction through one topplate screw 41. In the first direction, the two washers 711 are respectively attached to the upper and lower sides of the connecting part 62 (as shown in FIG. 6). In other words, one washer 711 and one nut 712 are located on the upper side of the connecting part 62, and the other washer 711 and the other nut 712 are located on the lower side of the connecting part 62.

When the connecting part 62 of the rigid position limiting structure 60 is connected to the rigid topplate 40, one nut 712 and one washer 711 are first sleeved on the topplate screw 41 in sequence, and then the topplate screw 41 passes through the topplate screw via 621 on the connecting part 62. The rigid position limiting structure 60 is in contact with the rigid topplate 40 in the first direction, and leaves space for accommodating the washer 711 and the nut 712. Then, the other washer 711 and the other nut 712 are sleeved on a part that is of the topplate screw 41 and that extends out of the connecting part 62 in sequence. The nuts 712 on the upper and lower sides of the connecting part 62 are separately tightened, so that the two washers 711 are respectively attached to the upper and lower sides of the connecting part 62. This completes a fastening connection between the connecting part 62 of the rigid position limiting structure 60 and the rigid topplate 40. That is, the rigid position limiting structure 60 is connected to the rigid topplate 40 through the connectors 70.

In this way, the rigid position limiting structure 60 and the rigid topplate 40 are fastened through the two nuts. This implements good connection stability and is not easy to loosen. In the working state, the heat dissipation system 1 effectively limits movement of the jet cooling assembly 20 in the first direction, and prevents the sealing part 30 from being separated from the jet cooling assembly 20; and the sealing part 30 is well compressed, so that the coolant outflow chamber 21 has good sealing effect.

For example, the nut 712 in the nut group 71 is a hexagonal nut. In some possible implementations, the nut 712 in the nut group 71 may alternatively be another type of nut.

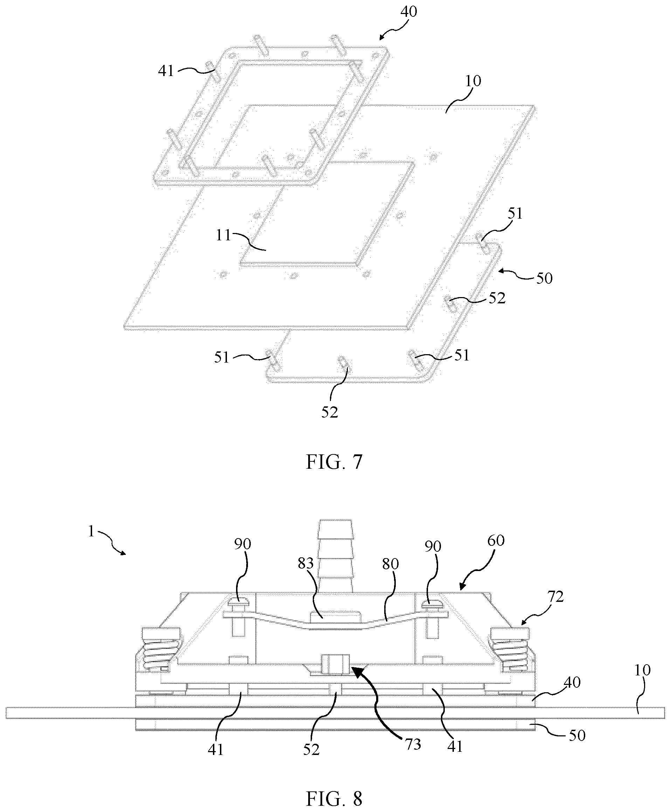

In addition, a quantity and installation locations of the nut groups 71 are not limited in this application. For example, the connector 70 in this application includes eight nut groups 71, and the eight nut groups 71 are distributed on the heat dissipation system 1 in an annular manner. FIG. 7 shows that eight topplate screws 41 are disposed on the rigid topplate 40, and two topplate screws 41 are disposed on each side of peripheries of the rigid topplate 40, and are located between two ribs 63. Correspondingly, eight topplate screw vias 621 are disposed on the connecting part 62. In some possible implementations, a quantity of nut groups 71 may be six, ten, or the like. The nut groups 71 may alternatively be disposed at other locations of the heat dissipation system 1.

The following describes a structure of the connector 70 between the three components: the rigid backplate 50, the rigid topplate 40, and the rigid position limiting structure 60.

Refer to FIG. 2 and FIG. 4 to FIG. 7. The connector 70 further includes a plurality of groups of spring screws 72, and each group of the spring screws 72 is located on the upper side of the connecting part 62, and fastens the connecting part 62, the rigid topplate 40, the substrate 10, and the rigid backplate 50 in sequence. A plurality of backplate screws 51 are disposed on a side that is of the rigid backplate 50 and that faces the substrate 10, the plurality of backplate screws 51 one-to-one correspond to the plurality of groups of spring screws 72, and backplate screw vias 622 one-to-one corresponding to the backplate screws 51 are disposed on the connecting part 62, the substrate 10, and the rigid topplate 40. Each of the backplate screws 51 has an inner thread, and the backplate screw 51 is configured to pass through the substrate 10, the rigid topplate 40, and the connecting part 62 in sequence, so that the spring screw 72 is in a thread connection with the inner thread of the corresponding backplate screw 51. In this way, the three components: the rigid backplate 50, the rigid topplate 40, and the rigid position limiting structure 60, are connected through the connectors 70.

That is, the connecting part 62 of the rigid position limiting structure 60, the rigid topplate 40, and the rigid backplate 50 are fastened to the substrate 10 through the spring screws 72. That the spring screws 72 serve as the connectors 70 can control installation force between the connecting part 62, the rigid topplate 40, and the rigid backplate 50, to prevent the heat generating device 11 from being damaged due to excessive force.

Before the connecting part 62 of the rigid position limiting structure 60 is fastened to the rigid topplate 40 through the nut groups 71, the connecting part 62 of the rigid position limiting structure 60, the rigid topplate 40, and the rigid backplate 50 are first connected through the spring screws 72 with preset installation force, and then the connecting part 62 of the rigid position limiting structure 60 is fastened to the rigid topplate 40 through the nut groups 71. Spring force provided by the spring screws 72 is designed to be only equal to rebound force obtained after the sealing part 30 is compressed, and the spring force is small, for example, 30 kg to 50 kg. In addition, the rigid position limiting structure 60 can ensure that the spring force is evenly applied to the sealing part 30. Such spring force has small pressure on a contact surface of the heat generating device 11, for example, 0.1 Mpa to 0.4 Mpa, to ensure that the heat generating device 11 is not damaged.

When the connecting part 62 of the rigid position limiting structure 60, the rigid topplate 40, and the rigid backplate 50 are fastened to the substrate 10 only through the spring screws 72, the nut groups 71 are not disposed. In this case, to ensure that the sealing part 30 remains in the sealed state when the heat dissipation system 1 is in the working state, installation force of the spring screw 72 needs to be increased, for example, the installation force is 400 kg to 600 kg. This increases pressure on the contact surface of the heat generating device 11, for example, the pressure is 2 Mpa to 4 Mpa, and this may damage the heat generating device 11.

In this way, in this application, after the rigid position limiting structure 60, the rigid topplate 40, and the rigid backplate 50 are fastened to each other through the spring screws 72 and the nut groups 71, an overall high rigid design is implemented. In addition to reducing pressure on the contact surface of the heat generating device 12, overall deformation of the heat dissipation system 1, especially deformation of the sealing part 30, is limited. This avoids a leakage of the coolant in the coolant outflow chamber 21, and avoids damage to the heat generating device 12.

In the foregoing embodiment, the rigid position limiting structure 60, the rigid topplate 40, and the rigid backplate 50 are fastened through the spring screws 72 and the backplate screws 51. In some possible implementations, the backplate screw 51 may not be disposed, inner thread holes are disposed on the connecting part 62, the rigid topplate 40, the substrate 10, and the rigid backplate 50 separately, and the spring screws 72 is in a thread connection with the inner thread holes on the connecting part 62, the rigid topplate 40, the substrate 10, and the rigid backplate 50 in sequence. In such setting, the rigid position limiting structure 60, the rigid topplate 40, and the rigid backplate 50 can also be fastened.

A quantity and installation locations of the spring screws 72 are not limited in this application. FIG. 4 shows four spring screws 72 that are respectively located at four corners of the connecting part 62 (connection points between the ribs 63 and the connecting part 62). Correspondingly, four backplate screw holes 51 are disposed at the corresponding locations on the rigid backplate 50, and four backplate screw holes 622 are respectively disposed at four corners on the connecting part 62, the substrate 10, and the rigid topplate 40. In some possible implementations, a quantity of spring screws 72 may be six, eight, or the like. The spring screws 72 may alternatively be disposed at other locations of the heat dissipation system 1.

Still refer to FIG. 4, FIG. 5, and FIG. 7. In some possible implementations, the connector 70 further includes a plurality of additional backplate screws 52 and a plurality of upper nuts 73. The plurality of additional backplate screws 52 are disposed on a side that is of the rigid backplate 50 and that faces the substrate 10, additional backplate screw vias one-to-one corresponding to the additional backplate screws 52 are disposed on the connecting part 62, the substrate 10, and the rigid topplate 40, and the additional backplate screws 52 are configured to pass through the substrate 10, the rigid topplate 40, and the connecting part 62 in sequence.

The plurality of upper nuts 73 one-to-one correspond to the additional backplate screws 52. Each of the upper nuts 73 is located on the upper side of the connecting part 62 of the rigid position limiting structure 60. After the additional backplate screws 52 pass through the substrate 10, the rigid topplate 40, and the connecting part 62 in sequence, the upper nut 73 is in a thread connection with a part that is of the additional backplate screw 52 and that extends out of the connecting part 62 of the rigid position limiting structure 60, so that the rigid backplate 50, the rigid topplate 40, and the connecting part 62 are fastened. That is, the rigid backplate 50, the rigid topplate 40, and the rigid position limiting structure 60 are fastened in a "single nut" form, and the rigid position limiting structure 60, the rigid topplate 40, and the rigid backplate 50 can also be fastened to each other. For example, the upper nut 73 is a hexagonal nut. In another implementation, the upper nut 73 may be a nut of another type.

The connecting part 62 of the rigid position limiting structure 60 and the rigid topplate 40 are fastened through the nut groups 71, and the rigid position limiting structure 60, the rigid topplate 40, and the rigid backplate 50 are fastened to each other through the additional backplate screws 52, the upper nuts 73, and the spring screws 72. Therefore, in some possible implementations, after the connecting part 62 of the rigid position limiting structure 60 and the rigid topplate 40 are fastened through the nut groups 71, the spring screws 72 may be removed.

After the rigid position limiting structure 60, the rigid topplate 40, and the rigid backplate 50 are connected through the spring screws 72, and after the installation force is controlled, the rigid position limiting structure 60, the rigid topplate 40, and the rigid backplate 50 are fastened through the additional backplate screws 52 and the upper nuts 73, and the connecting part 62 of the rigid position limiting structure 60 and the rigid topplate 40 are fastened through the nut groups 71. Therefore, after the spring screws 72 are removed, connection stability between the rigid position limiting structure 60, the rigid topplate 40, and the rigid backplate 50 is slightly affected. When the heat dissipation system 1 is in the working state, a stable connection between the rigid position limiting structure 60, the rigid topplate 40, and the rigid backplate 50 can still prevent the jet cooling assembly 20 from being separated from the heat generating device 11, so that the sealing part 30 remains in the sealed state. This avoids the leakage of the coolant in the coolant outflow chamber 21.

In some possible implementations, the rigid backplate 50, the rigid topplate 40, and the rigid position limiting structure 60 are fastened only in the "single nut" form.

In addition, a quantity and installation locations of additional topplate screws 41 are not limited in this application. For example, FIG. 7 shows that, in this application, the connector 70 includes four additional topplate screws 41 that are separately located between two topplate screws 41. Correspondingly, a quantity of upper nuts 73 is also four. In some possible implementations, a quantity of the additional topplate screws 41 may be one, two, six, or the like. The additional topplate screws 41 may alternatively be disposed at other locations of the rigid topplate 40.

In the foregoing embodiment, the rigid position limiting structure 60 and the rigid topplate 40 are fastened through two nuts. However, this application is not limited thereto. In some possible implementations, the rigid backplate 50, the rigid topplate 40, and the rigid position limiting structure 60 are fastened in the "single nut" form, and the rigid topplate 40 and the rigid position limiting structure 60 are fastened without using the nut groups 71.

Specifically, refer to FIG. 8 to FIG. 10. In this application, the connector 70 includes a plurality of topplate screws 41 and a plurality of fastening springs 80. The plurality of topplate screws 41 are disposed on the rigid topplate 40, every two topplate screws 41 are located on a same side of peripheries the rigid topplate 40, topplate screw vias 621 one-to-one corresponding to the topplate screws 41 are disposed on the connecting part 62, the topplate screws 41 are configured to pass through the topplate screw vias 621 on the connecting part 62, and each of the topplate screws 41 has an inner thread.

Each of the fastening springs 80 corresponds to two topplate screws 41 on a same side, each of the fastening springs 80 is located between the two ribs 63, locking holes 81 are disposed respectively at two ends of each of the fastening springs 80, and each locking hole 81 is configured for a locking screw 90 to pass through, so that the locking screw 90 is in a thread connection with the inner thread of the corresponding topplate screw 41.

When the connecting part 62 of the rigid position limiting structure 60 is connected to the rigid topplate 40, the topplate screw 41 passes through the topplate screw via 621 on the connecting part 62, and the locking screws 90 are separately inserted into the locking holes 81 at two ends of the fastening springs 80. The locking screw 90 at each end of the fastening spring 80 is in a thread connection with the inner thread of the corresponding topplate screw 41. In this way, the connecting part 62 of the rigid position limiting structure 60 is connected to the rigid topplate 40. Because the fastening springs 80 are connected to two topplate screws 41 at the same time, a connection point between the rigid topplate 40 and the connecting part 62 of the rigid position limiting structure 60 can be prevented from loosening.

A quantity and installation locations of fastening springs 80 are not limited in this application. For example, the connector 70 in this application includes four fastening springs 80 that are respectively located between two ribs 63. In some possible implementations, a quantity of the fastening springs 80 may be one, two, six, or the like. The fastening springs 80 may alternatively be disposed at other locations of the rigid topplate 40. For example, when ribs 63 are not disposed, the fastening springs 80 may correspond to two topplate screws 41 on different sides.

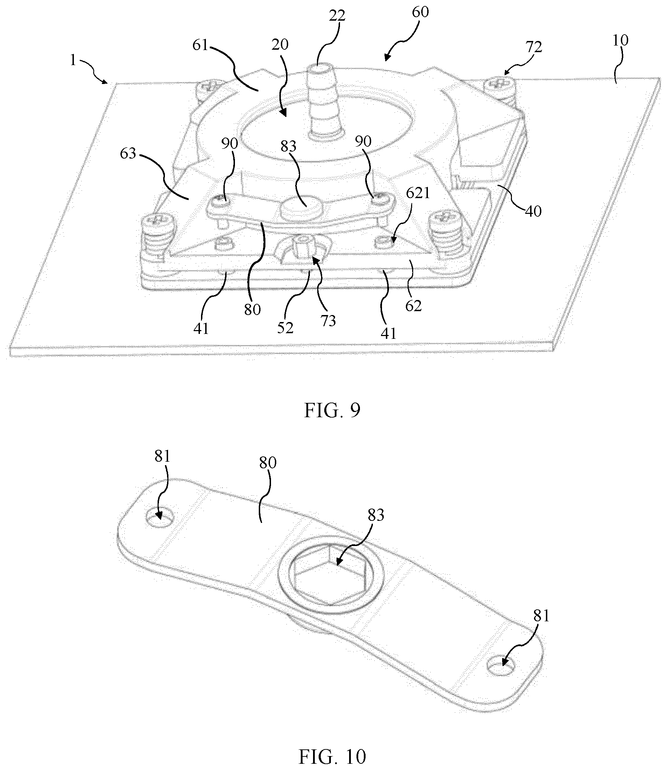

Still refer to FIG. 8 and FIG. 10. A nut slot 83 is disposed on a surface that is of each of the fastening springs 80 and that faces the connecting part 62. In the foregoing embodiment, the plurality of additional backplate screws 52 one-to-one correspond to the fastening springs 80. After the upper nut 73 is in the thread connection with the part that is of the additional backplate screw 52 and that extends out of the connecting part 62 (in the "single nut" connection form), each of the upper nuts 73 is circumferentially limited in the nut slot 83 of the corresponding fastening spring 80. In this way, the nut slot 83 for fastening a rear side of the fastening spring 80 may be fastened to the upper nut 73, to meet a limiting requirement. The fastening spring 80 is configured to limit rotation of the upper nut 73. This can effectively prevent the upper nut 73 from loosening, especially during transportation.

For example, the upper nut 73 is a hexagonal nut, the nut slot 83 is a hexagonal nut slot, and the hexagonal nut is limited in the hexagonal nut slot.

In the foregoing embodiment, the rigid position limiting structure 60, the rigid topplate 40, and the rigid backplate 50 are all fastened through the connectors 70. In some possible implementations, the rigid position limiting structure 60 is fastened to the rigid topplate 40 independently through connectors 70, and the rigid position limiting structure 60 is fastened to the rigid backplate 50 independently through connectors 70. In some possible implementations, the rigid position limiting structure 60 may not be disposed, and the rigid backplate 50, the rigid topplate 40, and the jet cooling assembly 20 are fastened. For example, an outer circumferential surface of the body of the jet cooling assembly 20 extends outwards in the radial direction to form an extending part, and the extending part has a similar structure to that of the connecting part 62. The extending part of the jet cooling assembly 20 is fastened to the rigid topplate 40 and the rigid backplate 50 through connectors, and can also limit movement of the jet cooling assembly 20 in the first direction. The structure of the connector 70 described in the foregoing embodiment may be used as the structure of the connector between the extending part of the jet cooling assembly 20 and the rigid topplate 40 and the rigid backplate 50. That is, refer to a specific form in which the connecting part 62, the rigid backplate 50, and the rigid topplate 40 are connected through the connectors 70 in the foregoing embodiment, for example, the connection form of "nut group", "single nut", or "spring screw".

This application further provides an electronic device, including the heat dissipation system 1 and the heat generating device 11 according to any one of the foregoing embodiments. The heat dissipation system 1 is configured to dissipate heat of the heat generating device 11 in the electronic device. The electronic device is, for example, a server like a blade server or a rack server. The jet cooling assembly 20 of the heat dissipation system 1 performs jet impingement cooling on the heat generating device 11 in the server.

This application further provides a liquid cooling system, including: the electronic device in the foregoing embodiment, and a cooling apparatus, where the cooling apparatus is connected to the jet cooling assembly 20 through a pipe, to provide a coolant for the jet cooling assembly 20. For example, the cooling apparatus is a CDU. The CDU is an industrial component that has a power function of temperature control, includes a plate heat exchanger (not shown in the figure), and can implement heat exchange on a primary side and a secondary side. The primary side is usually a cooling distribution unit, and a cold working medium provided by the cooling distribution unit flows under driving of a cooling pump. The secondary side is the electronic device in embodiments of this application. That is, the CDU implements heat exchange between the cold working medium in the cooling distribution unit and the coolant in the electronic device. For example, the cooling distribution unit is a heat exchange device in an environment, and is usually a cooling tower. A type of the cooling distribution unit is not limited in this application, and may be another apparatus that can provide a cold working medium.

In conclusion, in this application, movement in the first direction of the jet cooling assembly 20 in the heat dissipation system 1 is limited, so that the sealing part 30 that seals the jet cooling assembly 20 and the heat generating device 11 remains in the sealed state. In this way, the heat dissipation system 1 has good sealing performance, and a possibility of a coolant leakage is reduced.

## Claims

1. A heat dissipation system, configured to dissipate heat of a heat generating device on a substrate, wherein the heat dissipation system comprises:
a jet cooling assembly, wherein the jet cooling assembly has a coolant liquid inlet and a jet hole, and the jet hole faces the heat generating device, wherein
the heat generating device is disposed on a side that is of the substrate and that faces the jet cooling assembly, and an end part of the jet cooling assembly is in contact with a surface of the heat generating device;
a sealing part, configured to seal a part between the end part of the jet cooling assembly and the surface of the heat generating device;
a coolant outflow chamber, wherein the coolant outflow chamber is at least formed by the sealing part, the jet cooling assembly, and the heat generating device, and the jet hole communicates with the coolant outflow chamber;
a rigid topplate, around the heat generating device, disposed on a side that is of the substrate;
a rigid backplate, disposed, opposite to the rigid topplate, on the other side of the substrate and clamping the substrate together with the rigid topplate; and
a rigid position limiting structure, fastened to the substrate with the rigid topplate and/or the rigid backplate through connectors, wherein
in a first direction perpendicular to the substrate, there is height limiting space between the substrate and the rigid position limiting structure, and at least a part of the jet cooling assembly is located in the height limiting space; and
in the first direction, one end of the part of the jet cooling assembly located in the height limiting space is in contact with the heat generating device, and the other end is in contact with the rigid position limiting structure.

2. The heat dissipation system according to claim 1, wherein the rigid position limiting structure comprises:
an accommodating part, configured to accommodate the jet cooling assembly; and
a connecting part, extending outwards from an outer surface of the accommodating part, and fastened to the substrate with the rigid topplate and/or the rigid backplate through the connectors, wherein there is the height limiting space between the substrate and the accommodating part, wherein
in the first direction, the other end of the jet cooling assembly is in contact with the accommodating part.

3. The heat dissipation system according to claim 2, wherein the rigid position limiting structure further comprises:
a sleeve, wherein an inner chamber of the sleeve is the accommodating part, and the inner chamber of the sleeve adapts to a shape of the jet cooling assembly, wherein
the connecting part is a flange, the flange is formed by extending outwards in a radial direction from an end part that is of the sleeve and that faces the substrate, and the radial direction is perpendicular to the first direction.

4. The heat dissipation system according to claim 3, further comprising a plurality of ribs, wherein two ends of each of the ribs are respectively connected to the flange and the sleeve.

5. The heat dissipation system according to any one of claims 2 to 4, wherein the connector comprises:
a plurality of topplate screws, disposed on a side that is of the rigid topplate and that is opposite to the substrate, wherein each of the topplate screws is configured to pass through the connecting part; and
a plurality of nut groups one-to-one corresponding to the topplate screws, wherein each of the nut groups comprises two washers and two nuts, each of the nut groups clamps upper and lower sides of the connecting part through one of the topplate screws, and in the first direction, the two washers are respectively attached to the upper and lower sides of the connecting part.

6. The heat dissipation system according to claim 5, wherein the nut in the nut group is a hexagonal nut.

7. The heat dissipation system according to claim 5, wherein the connector further comprises a plurality of groups of spring screws, and each group of the spring screws is located on the upper side of the connecting part, and fastens the connecting part, the rigid topplate, the substrate, and the rigid backplate in sequence.

8. The heat dissipation system according to claim 7, wherein the connector further comprises a plurality of backplate screws, disposed on a side that is of the rigid backplate and that faces the substrate, and one-to-one corresponding to the spring screws, wherein each of the backplate screws has an inner thread, and the backplate screw is configured to pass through the substrate, the rigid topplate, and the connecting part in sequence, so that the spring screw is in a thread connection with the inner thread of the corresponding backplate screw.

9. The heat dissipation system according to claim 5, wherein the connector comprises eight nut groups, and the eight nut groups are distributed on the heat dissipation system in an annular manner.

10. The heat dissipation system according to any one of claims 2 to 4, wherein the connector comprises:
a plurality of topplate screws, disposed on a side that is of the rigid topplate and that is opposite to the substrate, wherein every two of the topplate screws are located on a same side of peripheries of the rigid topplate, each of the topplate screws is configured to pass through the connecting part, and each of the topplate screws has an inner thread; and
a plurality of fastening springs, wherein each of the fastening springs corresponds to two of the topplate screws on the same side, locking holes are respectively disposed at two ends of each of the fastening springs, and each of the locking holes is configured for a locking screw to pass through, so that the locking screw is in a thread connection with the inner thread of the corresponding topplate screw.

11. The heat dissipation system according to claim 10, wherein a nut slot is disposed on a surface that is of each of the fastening springs and that faces the connecting part, and the connector further comprises:
a plurality of additional backplate screws, disposed on a side that is of the rigid backplate and that faces the substrate, and one-to-one corresponding to the fastening springs, wherein each of the additional backplate screws is configured to pass through the substrate, the rigid topplate, and the connecting part in sequence; and
a plurality of upper nuts, one-to-one corresponding to the additional backplate screws, wherein each of the upper nuts is located on an upper side of the connecting part, and the upper nut is in a thread connection with a part that is of the additional backplate screw and that extends out of the connecting part, so that the rigid backplate, the rigid topplate, and the connecting part are fastened, and each of the upper nuts is circumferentially limited in the nut slot of the corresponding fastening spring.

12. The heat dissipation system according to claim 11, wherein the upper nut is a hexagonal nut, the nut slot is a hexagonal nut slot, and the hexagonal nut is limited in the hexagonal nut slot.

13. An electronic device, comprising the heat dissipation system and the heat generating device according to any one of claims 1 to 12, wherein the heat dissipation system is configured to dissipate heat for the heat generating device in the electronic device.

14. A liquid cooling system, comprising:
the electronic device according to claim 13; and
a cooling apparatus, wherein the cooling apparatus is connected to a jet cooling assembly through a pipe to provide a coolant for the jet cooling assembly.
